(19) **Europäisches Patentamt / European Patent Office / Office européen des brevets**

(11) **EP 4 768 964 A1**

(12) **EUROPEAN PATENT APPLICATION**
published in accordance with Art. 153(4) EPC

(43) Date of publication:
**01.07.2026 Bulletin 2026/27**

(21) Application number: **25848683.6**

(22) Date of filing: **30.06.2025**

(51) International Patent Classification (IPC):
$G01R\ 31/392^{(2019.01)}$  $G01R\ 31/396^{(2019.01)}$
$G01R\ 31/3842^{(2019.01)}$  $G01R\ 31/367^{(2019.01)}$
$G01R\ 31/36^{(2020.01)}$

(52) Cooperative Patent Classification (CPC):
**G01R 31/36; G01R 31/367; G01R 31/3842;
G01R 31/392; G01R 31/396**

(86) International application number:
**PCT/KR2025/009249**

(87) International publication number:
**WO 2026/029394 (05.02.2026 Gazette 2026/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.08.2024 KR 20240102814**

(71) Applicant: **LG Energy Solution, Ltd.
Seoul 07335 (KR)**

(72) Inventors:
• **LEE, Hyeon Ho
Daejeon 34122 (KR)**
• **JUN, Gwang Hoon
Daejeon 34122 (KR)**
• **CHUNG, Mi Kyung
Daejeon 34122 (KR)**
• **JEGAL, Seon Young
Daejeon 34122 (KR)**
• **MOON, Hee Joon
Daejeon 34122 (KR)**

(74) Representative: **Plasseraud IP
104 Rue de Richelieu
CS92104
75080 Paris Cedex 02 (FR)**

(54) **BATTERY DIAGNOSTIC DEVICE AND METHOD THEREFOR**

(57) A battery diagnosis device according to an embodiment of this document includes a memory configured to store at least one instruction and at least one processor configured to execute the at least one instruction, and the at least one processor is configured to acquire an open circuit voltage (OCV) for each first charge amount according to a charge amount indicating an amount of charge charged in a battery cell, based on at least one of charging data of the battery cell, discharging data of the battery cell, or any combination thereof, acquire a degradation indicator based on the open circuit voltage for each first charge amount, and diagnose a state of the battery cell based on the degradation indicator.

FIG.1

**Description**

## TECHNICAL FIELD

### Cross-reference to Related Applications

This application claims priority from Korean Patent Application No. 10-2024-0102814, filed on August 2, 2024, the disclosure of which is incorporated by reference herein.

### Technical Field

Embodiments disclosed in this document relate to a battery diagnosis device and a battery diagnosis method.

## BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

With the proliferation of electronic devices due to the Fourth Industrial Revolution, battery usage is increasing dramatically. Batteries are in the spotlight as an essential energy source in various applications, and accordingly, the importance of technology for diagnosing a battery state to improve battery performance and reliability is increasing.

In particular, technologies for improving the accuracy of diagnosing degradation indicator, which indicate the degree of degradation of the battery, are attracting attention. When the accuracy of diagnosing the degradation indicator of the battery is improved, problems that may occur due to the degradation of the battery may be checked and prevented in advance.

## DISCLOSURE OF THE INVENTION

### TECHNICAL PROBLEM

Embodiments disclosed in this document provide a battery diagnosis device and a battery diagnosis method that reduce the resources required for battery diagnosis by reducing the resources required to acquire charging data and discharging data used to acquire degradation indicators.

Embodiments disclosed in this document provide a battery diagnosis device and a battery diagnosis method that identify degradation indicators while reducing the resources required to acquire charging data and discharging data used to acquire degradation indicators.

Embodiments disclosed in this document provide a battery diagnosis device and a battery diagnosis method that monitor problems that may occur due to battery degradation by identifying degradation indicators.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery diagnosis device according to an embodiment of this document includes a memory configured to store at least one instruction and at least one processor configured to execute the at least one instruction.

According to an embodiment, the at least one processor is configured to acquire an open circuit voltage (OCV) for each first charge amount according to a charge amount indicating an amount of charge charged in a battery cell, based on at least one of charging data of the battery cell, discharging data of the battery cell, or any combination thereof, acquire a degradation indicator based on the open circuit voltage for each first charge amount, and diagnose a state of the battery cell based on the degradation indicator.

According to an embodiment, the at least one processor may be configured to identify an open circuit voltage corresponding to the charge amount based on a) a first voltage value of the battery cell corresponding to the charge amount and included in the charging data, b) a first current value of the battery cell corresponding to the charge amount and included in the charging data, c) a second voltage value of the battery cell corresponding to the charge amount and included in the discharging data, and d) a second current value of the battery cell corresponding to the charge amount and included in the discharging data, and identify the open circuit voltage for each first charge amount based on the charge amount and the open circuit voltage.

According to an embodiment, the at least one processor may be configured to identify a voltage value of the battery cell corresponding to a current value of the battery cell when the current value of the battery cell is less than a specified current value, according to a linear equation identified based on a relationship between the first current value and the first voltage value and a relationship between the second current value and the second voltage value, and identify an open circuit voltage corresponding to the charge amount based on a voltage value of the battery cell.

According to an embodiment, the at least one processor may be configured to acquire a parameter based on at least one of i) an optimization algorithm, ii) an open circuit voltage for each charge amount of the battery cell in a middle of life (MOL) state indicated by the open circuit voltage for each first charge amount, iii) an open circuit voltage for each third charge amount of the battery cell in a beginning of life (BOL) state, iv) an open circuit potential (OCP) for each charge amount of the battery cell in the BOL state, or v) any combination thereof, and acquire the degradation indicator based on the parameter.

According to an embodiment, the at least one processor may be configured to perform the optimization algorithm using a genetic algorithm (GA).

According to an embodiment, the at least one processor may be configured to acquire at least one of the charging data, the discharging data, or any combination thereof, based on a charging and discharging profile through which the battery cell is charged with a current value higher than a reference current a specific number of times less than a reference number of times from a lower limit amount of charge higher than a first reference amount of charge to an upper limit amount of charge lower than a second reference amount of charge, and the battery cell is discharged at a current value a specific number of times from the upper limit amount of charge to the lower limit amount of charge.

According to an embodiment, the degradation indicator may include a loss of lithium inventory (LLI), which includes a first parameter related to lithium loss of the battery cell in a middle of life (MOL) compared to a beginning of life (BOL), a first loss of active material (LAM), which includes a second parameter related to a loss of active material in a negative electrode plate of the battery cell in the MOL compared to the BOL, or a second loss of active material (LAM), which includes a third parameter related to a loss of active material in a positive electrode plate of the battery cell in the MOL compared to the BOL.

A battery diagnosis method according to an embodiment of this document includes an operation of acquiring an open circuit voltage (OCV) for each first charge amount according to a charge amount indicating an amount of charge charged in a battery cell, based on at least one of charging data of the battery cell, discharging data of the battery cell, or any combination thereof, an operation of acquiring a degradation indicator based on the open circuit voltage for each first charge amount, and an operation of diagnosing a state of the battery cell based on the degradation indicator.

According to an embodiment, the operation of acquiring the open circuit voltage (OCV) for each first charge amount according to a charge amount indicating an amount of charge charged in a battery cell, based on at least one of charging data of the battery cell, discharging data of the battery cell, or any combination thereof may include an operation of identifying an open circuit voltage corresponding to the charge amount based on a) a first voltage value of the battery cell corresponding to the charge amount and included in the charging data, b) a first current value of the battery cell corresponding to the charge amount and included in the charging data, c) a second voltage value of the battery cell corresponding to the charge amount and included in the discharging data, and d) a second current value of the battery cell corresponding to the charge amount and included in the discharging data, and an operation of identifying the open circuit voltage for each first charge amount based on the charge amount and the open circuit voltage.

According to an embodiment, the operation of identifying the open circuit voltage corresponding to the charge amount based on a) the first voltage value of the battery cell corresponding to the charge amount and included in the charging data, b) the first current value of the battery cell corresponding to the charge amount and included in the charging data, c) the second voltage value of the battery cell corresponding to the charge amount and included in the discharging data, and d) the second current value of the battery cell corresponding to the charge amount and included in the discharging data may include an operation of identifying a voltage value of the battery cell corresponding to a current value of the battery cell when the current value of the battery cell is less than a specified current value, according to a linear equation identified based on a relationship between the first current value and the first voltage value and a relationship between the second current value and the second voltage value, and an operation of identifying an open circuit voltage corresponding to the charge amount based on a voltage value of the battery cell.

According to an embodiment, the operation of acquiring the degradation indicator based on the open circuit voltage for each first charge amount may include an operation of acquiring a parameter based on at least one of i) an optimization algorithm, ii) an open circuit voltage for each charge amount of the battery cell in a middle of life (MOL) state indicated by the open circuit voltage for each first charge amount, iii) an open circuit voltage for each third charge amount of the battery cell in a beginning of life (BOL) state, iv) an open circuit potential (OCP) for each charge amount of the battery cell in the BOL state, or v) any combination thereof, and an operation of acquiring the degradation indicator based on the parameter.

According to an embodiment, the operation of acquiring the parameter based on at least one of i) the optimization algorithm, ii) the open circuit voltage for each charge amount of the battery cell in the MOL state indicated by the open circuit voltage for each first charge amount, iii) the open circuit voltage for each third charge amount of the battery cell in the BOL state, iv) the open circuit potential for each charge amount of the battery cell in the BOL state, or v) any combination thereof may include an operation of performing the optimization algorithm using a genetic algorithm (GA).

According to an embodiment, the battery diagnosis method may further include an operation of charging the battery cell with a current value higher than a reference current a specific number of times less than a reference number of times from a lower limit amount of charge higher than a first reference amount of charge to an upper limit amount of charge lower than a second reference amount of charge, and an operation of acquiring at least one of the charging data, the discharging data, or any combination thereof based on a charging and discharging profile through which the battery cell is discharged at a current value a specific number of times from the upper limit amount of charge to the lower limit amount of charge.

According to an embodiment, the degradation indicator may include a loss of lithium inventory (LLI), which includes a first parameter related to lithium loss of the battery cell in a middle of life (MOL) compared to a beginning of life (BOL), a first loss of active material (LAM), which includes a second parameter related to a loss of active material in a negative electrode plate of the battery cell in the MOL compared to the BOL, or a second loss of active material (LAM), which includes a third parameter related to a loss of active material in a positive electrode plate of the battery cell in the MOL compared to the BOL.

## ADVANTAGEOUS EFFECTS

The present technology can reduce the resources required for battery diagnosis by reducing the resources required to acquire charging data and discharging data used to acquire degradation indicators.

In addition, the present technology can identify degradation indicators while reducing the resources required to acquire charging data and discharging data used to acquire degradation indicators.

In addition, the present technology can monitor problems that may occur due to battery degradation by identifying degradation indicators.

In addition, various effects that are directly or indirectly identified through this document can be provided.

## BRIEF DESCRIPTION OF THE DRAWINGS

FIG. 1 is a block diagram illustrating a battery pack, in a battery diagnosis device and battery diagnosis method according to an embodiment of this document.

FIG. 2 is a block diagram illustrating the configuration of a battery diagnosis device, in a battery diagnosis device and a battery diagnosis method according to an embodiment of this document.

FIG. 3 illustrates examples of charging data and discharging data, in a battery diagnosis device and a battery diagnosis method according to an embodiment of this document.

FIG. 4 illustrates an example of acquiring an open circuit voltage for each first charge amount, in a battery diagnosis device and a battery diagnosis method according to an embodiment of this document.

FIG. 5 illustrates an example of executing an optimization algorithm, in a battery diagnosis device and a battery diagnosis method according to an embodiment of this document.

FIG. 6 illustrates an example of a degradation indicator, in a battery diagnosis device and a battery diagnosis method according to an embodiment of this document.

FIG. 7 illustrates an example of a flow of operations of a battery diagnosis device that diagnoses a state of a battery cell based on a degradation indicator, in a battery diagnosis device and a battery diagnosis method according to an embodiment of this document.

FIG. 8 is a block diagram illustrating a hardware configuration of a computing system that performs a battery diagnosis method, in a battery diagnosis device and battery diagnosis method according to an embodiment of this document.

## MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

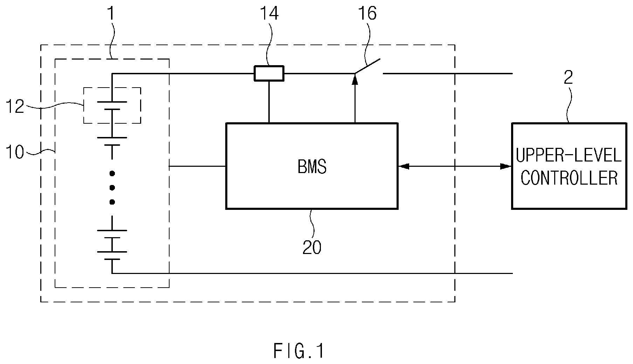

Hereinafter, embodiments of this document will be described in detail with reference to FIGS. 1 to 8.

FIG. 1 is a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV) or an energy storage system (ESS).

According to an embodiment, the battery unit 12 may include at least one battery unit 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

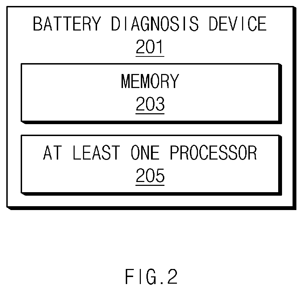

According to an embodiment, the battery management system 20 may include a battery diagnosis device 201 of FIG. 2. According to another embodiment, the battery management system 20 may be a different system from the battery diagnosis device 201 of FIG. 2. That is, the battery diagnosis device 201 of FIG. 2 may be included in the battery pack 1 or may be configured as another device external to the battery pack 1. Hereinafter, for convenience of description, the description will be made on the assumption that the battery diagnosis device 201 is composed of another device external to the battery pack 1. In addition, the operation of the battery diagnosis device 201 described below may be performed by a BMS in the vehicle, and may also be performed by various devices such as a server, a cloud, a charger, or a discharger.

FIG. 2 is a block diagram showing the configuration of a battery diagnosis device, in a battery diagnosis device and battery diagnosis method according to an embodiment of this document.

Referring to FIG. 2, the battery diagnosis device 201 may include a memory 203 and at least one processor 205. The memory 203 may store at least one instruction. The at least one processor 205 may execute at least one instruction.

According to an embodiment, at least one processor 205 of the battery diagnosis device 201 may perform a reference performance test (RPT) to diagnose a state of the battery cell (e.g., the battery cell 10) of FIG. 1.

According to an embodiment, while performing the reference performance test (RPT), at least one processor 205 of the battery diagnosis device 201 may charge or discharge the battery cell and acquire electrical parameter values (e.g., a current, a voltage, and an SOC)) of the battery cell. The SOC may indicate an amount of charge charged in the battery cell.

According to an embodiment, at least one processor 205 of the battery diagnosis device 201 may acquire at least one of charging data and discharging data, based on a charging and discharging profile through which the battery cell is charged with a current value higher than a reference current a specific number of times less than a reference number of times from a lower limit amount of charge higher than a first reference amount of charge to an upper limit amount of charge lower than a second reference amount of charge, and the battery cell is discharged at a current value a specific number of times from the upper limit amount of charge to the lower limit amount of charge. At least one processor 205 of the battery diagnosis device 201 may diagnose the state of the battery cell based on charging data and discharging data. Furthermore, at least one processor 205 of the battery diagnosis device 201 may measure an open circuit voltage even through a current greater than or equal to a specified current value. According to an embodiment, the temporal and electrical resources consumed by the battery diagnosis device 201 to diagnose the state of the battery cell may be less than the temporal and electrical resources consumed by an existing battery diagnosis device to diagnose the state of the battery cell.

The open circuit voltage may indicate a voltage in a state in which the battery cell is not connected to an external circuit and no current flows.

According to an embodiment, at least one processor 205 of the battery diagnosis device 201 may acquire the open circuit voltage for each charge amount of the battery cell in a middle of life (MOL) state based on charging data and discharging data.

According to an embodiment, at least one processor 205 of the battery diagnosis device 201 may acquire degradation indicators (e.g., a first LAM, which is the loss of active material (LAM) of a negative electrode plate, a second LAM, which is the LAM of a positive electrode plate, and a loss of lithium inventory (LLI) based on an open circuit voltage for each SOC of the battery cell in the MOL state, an open circuit voltage for each SOC of the battery cell in a beginning of life (BOL) state, and an open circuit potential (OCP) of the battery cell in the BOL state.

The first LAM may include a second parameter related to a loss of an active material of a negative electrode plate of the battery cell at the MOL compared to the BOL. The second LAM may include a third parameter related to a loss of an active material of a positive electrode plate of the battery cell at the MOL compared to the BOL. The LLI may include a first parameter related to lithium loss of the battery cell at the MOL compared to the BOL.

According to an embodiment, at least one processor 205 of the battery diagnosis device 201 may acquire a final degradation indicator by correcting the acquired degradation indicator.

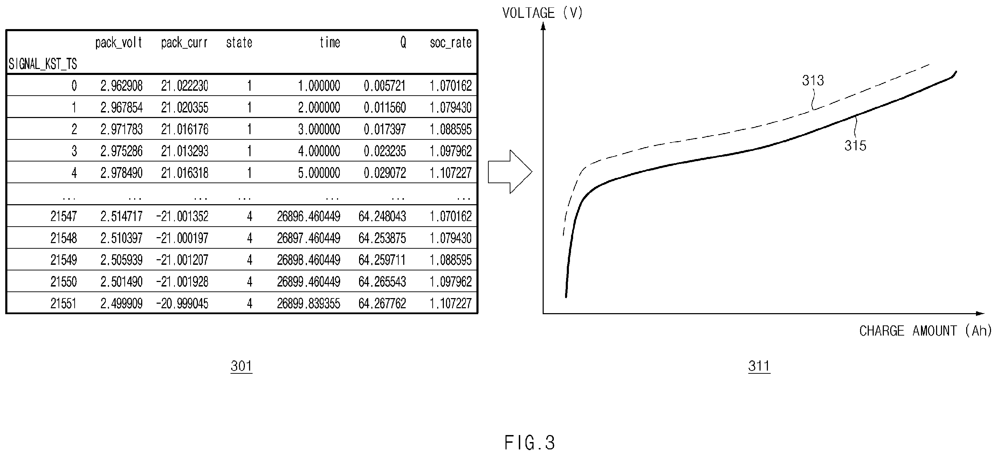

The contents of acquiring the final degradation indicator by efficiently using the temporal and electrical resources of the battery diagnosis device 201 will be described below in FIGS. 3 to 6.

FIG. 3 illustrates examples of charging data and discharging data in a battery diagnosis device and a battery diagnosis method according to an embodiment of this document.

Referring to FIG. 3, a table 301 may represent charging data and discharging data of the battery cell (e.g., the battery cell 10) of FIG. 1 acquired by the battery diagnosis device 201 according to an embodiment. A graph 311 may represent an open circuit voltage according to the SOC identified based on the table 301. A first line 313 of the graph 311 may represent an open circuit voltage identified based on the charging data. A second line 315 may represent an open circuit voltage identified based on the discharging data.

According to an embodiment, the first line 313, which represents an open circuit voltage identified based on the charging data, and the second line 315, which represents an open circuit voltage identified based on the discharging data, may not match.

According to an embodiment, at least one processor 205 of the battery diagnosis device 201 may separate the charging data and discharging data included in the table 301 according to the SOC so as to identify a single open circuit voltage according to the SOC.

For example, when the at least one processor 205 of the battery diagnosis device 201 may acquire two voltage values and two current values according to a specific SOC when identifying charging data and discharging data based on a profile through which charging and discharging are performed once.

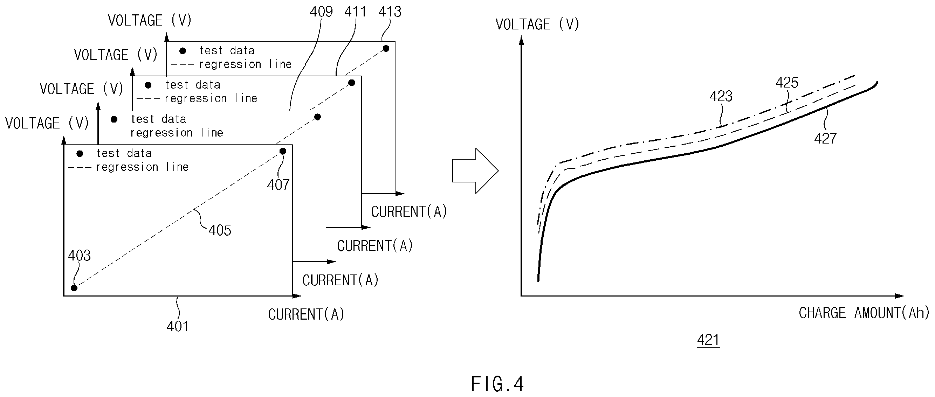

FIG. 4 illustrates an example of acquiring an open circuit voltage for each first SOC, in a battery diagnosis device and a battery diagnosis method according to an embodiment of this document.

Referring to FIG. 4, a first graph 401 may include a voltage graph for a current corresponding to the first SOC. A second graph 409 may include a voltage graph for current corresponding to a second SOC. A third graph 411 may include a voltage graph for a current corresponding to a third SOC. A fourth graph 413 may include a voltage graph for a current corresponding to a fourth SOC. A fifth graph 421 may include an open circuit voltage graph according to the SOC. A first line 423 of the fifth graph 421 may represent an open circuit voltage identified based on charging data. A second line 425 of the fifth graph 421 may represent an open circuit voltage identified based on the charging data and discharging data. A third line 427 of the fifth graph 421 may represent an open circuit voltage identified based on the discharging data.

According to an embodiment, the first graph 401 may correspond to the first SOC, the second graph 409 may correspond to the second SOC, the third graph 411 may correspond to the third SOC, and the fourth graph 413 may correspond to the fourth SOC.

According to an embodiment, the at least one processor may be configured to identify an open circuit voltage corresponding to the SOC based on a) a first voltage value of the battery cell (e.g., a voltage value corresponding to a second point 407) corresponding to the SOC (e.g., the first SOC, the second SOC, the third SOC, and the fourth SOC) and included in the charging data, b) a first current value (e.g., a current value corresponding to the second point 407) of the battery cell corresponding to the SOC and included in the charging data, c) a second voltage value (e.g., a voltage value corresponding to a first point 403) of the battery cell corresponding to the SOC and included in the discharging data, and d) a second current value (e.g., a current value corresponding to the first point 403) of the battery cell corresponding to the SOC and included in the discharging data, and identify the open circuit voltage for each SOC based on the SOC and the open circuit voltage.

According to an embodiment, in the first graph 401, the first point 403 may correspond to a second current value of the battery cell (e.g., the battery cell 10 of FIG. 1) corresponding to the first SOC and included in the discharging data, and a second voltage value of the battery cell corresponding to the first SOC and included in the discharging data.

According to an embodiment, in the first graph 401, the second point 407 may correspond to a first current value of the battery cell corresponding to the first SOC and included in the charging data, and correspond to a first voltage value of the battery cell corresponding to the first SOC and included in the discharging data.

According to an embodiment, at least one processor 205 of the battery diagnosis device 201 may identify a regression equation identified based on the first point 403 and the second point 407. At least one processor 205 of the battery diagnosis device 201 may identify a regression line 405 based on a linear equation, which is a regression equation. In other words, the regression line 405 may represent a linear equation identified based on a relationship between the first current value and the first voltage value, and a relationship between the second current value and the second voltage value.

According to an embodiment, at least one processor 205 of the battery diagnosis device 201 may identify a voltage value of a battery cell corresponding to a case where a current value of the battery cell is less than a specified current value (e.g., the current value of the battery cell is approximately 0 A (ampere)), based on the regression line 405. The at least one processor 205 of the battery diagnosis device 201 may identify an open circuit voltage according to the first SOC based on a voltage value of the battery cell corresponding to a case where the current value of the battery cell is less than the specified current value.

According to an embodiment, at least one processor 205 of the battery diagnosis device 201 may identify an open circuit voltage according to the second SOC based on the second graph 409.

According to an embodiment, at least one processor 205 of the battery diagnosis device 201 may identify an open circuit voltage according to the third SOC based on the third graph 411.

According to an embodiment, at least one processor 205 of the battery diagnosis device 201 may identify an open circuit voltage according to the fourth SOC based on the fourth graph 413.

According to an embodiment, at least one processor 205 of the battery diagnosis device 201 may identify an open circuit voltage for each SOC, as shown in the second line 425 of the fifth graph 421, based on the open circuit voltage according to the first SOC, the open circuit voltage according to the second SOC, the open circuit voltage according to the third SOC, and the open circuit voltage according to the fourth SOC.

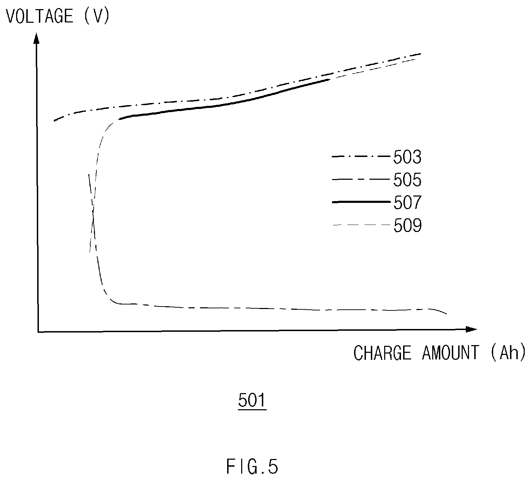

FIG. 5 illustrates an example of an optimization algorithm execution in a battery diagnosis device and battery diagnosis method according to an embodiment of this document.

Referring to FIG. 5, graph 501 may represent the voltage for an SOC of the battery cell (e.g., the battery cell 10 of FIG. 1). A positive potential 503 may include a positive potential of the battery cell estimated at an MOL point in time. A negative potential 505 may include a negative potential of the battery cell estimated at the MOL point in time. A first open circuit voltage 507 may include an open circuit voltage of the battery cell identified at the MOL point in time. A second open circuit voltage 509 may represent the open circuit voltage of the battery cell identified based on the positive potential 503 and the negative potential 505. For example, the second open circuit voltage 509 may represent a difference between the positive potential 503 and the negative potential 505.

According to an embodiment, the at least one processor 205 of the battery diagnosis device 201 may acquire a parameter based on at least one of i) an optimization algorithm (e.g., a genetic algorithm (GA)), ii) an open circuit voltage for each second SOC of the battery cell in the middle of life (MOL) state indicated by the open circuit voltage for each first SOC, iii) an open circuit voltage for each third SOC of the battery cell in the beginning of life (BOL) state, iv) an open circuit potential (OCP) for each SOC of the battery cell in the BOL state, or v) any combination thereof, and acquire the degradation indicator based on the parameter.

At least one processor 205 of the battery diagnosis device 201 according to an embodiment may acquire the positive potential 503 and the negative potential 505 using the positive potential at the BOL point in time and the negative potential at the BOL point in time, respectively. For example, at least one processor 205 of the battery diagnosis device 201 may acquire the positive potential 503 and the negative potential 505 by applying different shrinkage rates to SOC regions. That is, at least one processor 205 of the battery diagnosis device 201 may acquire the parameter corresponding to each SOC region.

At least one processor 205 of the battery diagnosis device 201 according to an embodiment may calculate a deviation between the second open circuit voltage 509 in the BOL state and the first open circuit voltage 507 in the MOL state in each SOC range of a battery cell. A processor according to an embodiment may calculate the parameter that minimizes the deviation across the entire SOC range.

When the deviation is minimized, at least one processor 205 of the battery diagnosis device 201 may acquire the second open circuit voltage 509 that is substantially equal to the first open circuit voltage 507. That is, at least one processor 205 of the battery diagnosis device 201 may perform optimization on the parameter by identifying the positive potential 503 and the negative potential 505 for matching the first open circuit voltage 507 and the second open circuit voltage 509.

In an embodiment, at least one processor 205 of the battery diagnosis device 201 may acquire the positive potential 503 and the negative potential 505 corresponding to the second open circuit voltage 509 acquired at the MOL point in time by acquiring the second open circuit voltage 509 that is substantially equal to the first open circuit voltage 507.

For example, at least one processor 205 of the battery diagnosis device 201 may compare the positive potential 503 and the negative potential 505 with the positive potential and the negative potential acquired at the BOL point in time, respectively, to acquire a shrinkage rate for the positive potential, a mobility for the positive potential, a shrinkage rate for the negative potential, and/or a mobility for the negative potential.

According to an embodiment, at least one processor 205 of the battery diagnosis device 201 may diagnose the state of the battery cell using the parameters. For example, at least one processor 205 of the battery diagnosis device 201 may acquire a degradation indicator using Equations 1 to 3.

[Equation 1]

$$LAMn = (BOL_{OCPn\_shrink} - MOL_{OCPn\_shrink}) / (BOL_{OCPn\_shrink})$$

Referring to Equation 1, a loss of active material (LAMn) may represent a degree to which an active material of a battery contained in a negative electrode is lost. $BOL_{OCPn\_shrink}$ may represent the shrinkage rate of the negative electrode potential measured at the BOL point in time. As an example, $BOL_{OCPn\_shrink}$ may be 1, but is not limited thereto. $MOL_{OCPn\_shrink}$ may represent the shrinkage rate of the negative electrode potential estimated at the MOL point in time. The shrinkage rate of the negative potential estimated at the MOL point in time may be included in the parameters optimized by a specified algorithm.

[Equation 2]

$$LAMp = (BOL_{OCPp\_shrink} - MOL_{OCPp\_shrink}) / (BOL_{OCPp\_shrink})$$

Referring to Equation 2, a loss of active material potential (LAMp) may represent the degree to which the active material of the battery contained in the positive electrode $BOL_{OCPp\_shift}$ is lost. may represent the shrinkage rate of the positive potential measured at the BOL point in time. As an $BOL_{OCPp\_shift}$ example, may be 1, but is not limited thereto. $MOL_{OCPp\_shift}$ may represent the shrinkage rate of the positive potential estimated at the MOL point in time. The shrinkage rate of the positive potential estimated at the MOL point in time may be included in the parameters optimized by a specified algorithm.

[Equation 3]

$$LLI = (MOL_{OCPn\_shift} - MOL_{OCPp\_shift}) - (BOL_{OCPn\_shift} - (BOL_{OCPp\_shift})$$

Referring to Equation 3, the LLI may represent a capacity loss of lithium contained in the battery cell. $MOL_{OCPn\_shift}$ may represent the mobility of the negative electrode potential estimated at the MOL point in time. $MOL_{OCPp\_shift}$ may represent the mobility of the positive electrode potential estimated at the MOL point in time. $BOL_{OCPn\_shift}$ may represent the mobility of the negative electrode potential acquired at the BOL point in time. $BOL_{OCPp\_shift}$ may represent the mobility of the positive electrode potential acquired at the BOL point in time.

For example, $MOL_{OCPn\_shift}$ and $MOL_{OCPp\_shift}$ may be included in the parameters optimized by a specified algorithm. $BOL_{OCPn\_shrink}$ and $BOL_{OCPn\_shift}$ may be included in battery data at the BOL state.

At least one processor 205 of the battery diagnosis device 201 according to an embodiment may diagnose the state of the battery cell using the LAMn, the LAMp, and/or the LLI. For example, at least one processor 205 of the battery diagnosis device 201 may provide a diagnosis result of diagnosing the state of the battery cell. For example, at least one processor 205 of the battery diagnosis device 201 may provide the diagnosis result to a user by transmitting the diagnosis result to an external electronic device (e.g., a server). However, it is not limited thereto.

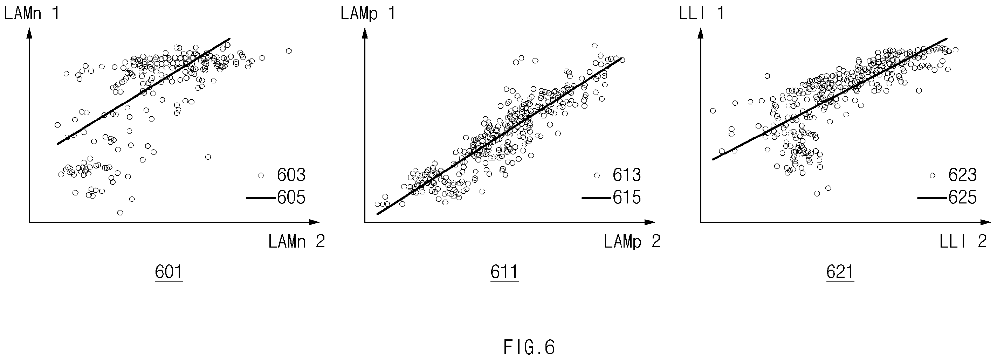

FIG. 6 illustrates examples of degradation indicators in a battery diagnosis device and a battery diagnosis method according to an embodiment of this document.

Referring to FIG. 6, a first graph 601 may include points 603 representing a relationship between an experimentally acquired LAM of a negative electrode plate (e.g., an LAMn2) and an LAM of a negative electrode plate (e.g., an LAMn1) identified through an optimization algorithm, and a first line 605 representing a regression equation based on the points 603.

A second graph 611 may include points 613 representing a relationship between an experimentally acquired LAM of a positive electrode plate (e.g., an LAMp2) and an LAM of a positive electrode plate (e.g., an LAMp1) identified through an optimization algorithm, and a second line 615 representing a regression equation based on the points 613.

A third graph 621 may include points 623 representing a relationship between an experimentally acquired LLI of a positive electrode plate (e.g., an LLI2) and an LLI of a positive electrode plate (e.g., an LLI1) identified through an optimization algorithm, and a third line 625 representing a regression equation according to the points 623.

According to an embodiment, at least one processor 205 of the battery diagnosis device 201 may correct the LAM of the negative electrode plate identified through an optimization algorithm to the final LAM of the negative electrode plate (e.g., the first LAM) based on a preset relational expression identified according to the first line 605.

According to an embodiment, at least one processor 205 of the battery diagnosis device 201 may correct the LAM of the positive electrode plate identified through an optimization algorithm to the final LAM of the positive electrode plate (e.g., the second LAM) based on a preset relational expression identified according to the second line 615.

According to an embodiment, at least one processor 205 of the battery diagnosis device 201 may correct the LLI identified through an optimization algorithm to the final LLI of the negative electrode plate based on a relational expression identified according to the third line 625.

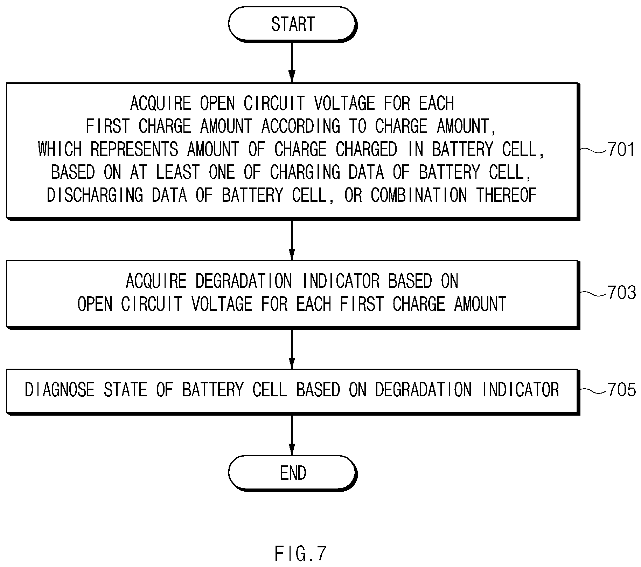

FIG. 7 illustrates an example of a flow of operations of a battery diagnosis device that diagnoses the state of a battery cell based on the degradation indicator in a battery diagnosis device and a battery diagnosis method according to an embodiment of this document.

Hereinafter, it is assumed that the battery diagnosis device 201 of FIG. 2 performs the process of FIG. 7. Furthermore, in the description of FIG. 7, the operations described as being performed by the battery diagnosis device may be understood as being performed by at least one processor 205 of the battery diagnosis device 201 of FIG. 2.

Referring to FIG. 7, in a first operation 701, at least one processor 205 of the battery diagnosis device 201 according to an embodiment may acquire an open circuit voltage for each first SOC according to a SOC, which represents an amount of charge charged in a battery cell, based on at least one of charging data of the battery cell, discharging data of the battery cell, or a combination thereof.

In a second operation 703, at least one processor 205 of the battery diagnosis device 201 according to an embodiment may acquire a degradation indicator based on the open circuit voltage for each first SOC.

In a third operation 705, at least one processor 205 of the battery diagnosis device 201 according to an embodiment may diagnose a state of the battery cell based on the degradation indicator.

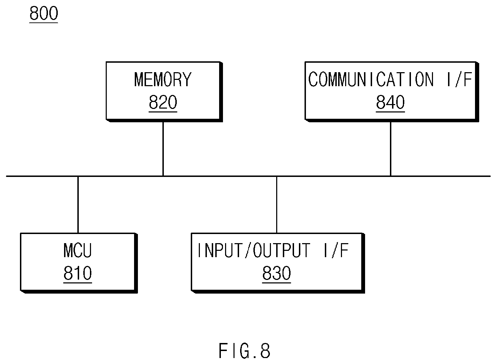

FIG. 8 is a block diagram illustrating a hardware configuration of a computing system that performs a battery diagnosis method, in a battery diagnosis device and battery diagnosis method according to an embodiment of this document.

Referring to FIG. 8, a computing system 800 according to an embodiment disclosed in this document may include an MCU 810, a memory 820, an input/output I/F 830, and a communication I/F 840.

The MCU 810 may be one or more processors that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 201 shown in FIGS. 2 to 5 described above.

The memory 820 may store various programs such as the battery cell data collection program, the graph generation program, the data analysis program, the data decomposition algorithm, the normalization program, and the battery cell diagnosis program.

A plurality of such memories 820 may be provided as needed. The memory 820 may be a volatile memory or a nonvolatile memory. The memory 820 used as the volatile memory may be RAM, DRAM, SRAM, etc. The memory 820 used as the nonvolatile memory may be ROM, PROM, EAROM, EPROM, EEPROM, flash memory, etc. The examples of the memories 820 listed above are only examples, but are not limited to these examples.

The input/output I/F 830 may provide an interface that allows data to be transmitted and received by connecting an input device (not shown) such as a keyboard, mouse, or touch panel and an output device (not shown) such as a display with the MCU 810.

The communication I/F 840 is a configuration that can transmit and receive various data with the server, and may be various devices that can support wired or wireless communication. For example, the battery diagnosis device 201 may transmit and receive various information including shape models of battery cells, etc. to and from a separately provided external server through the communication I/F 840.

In this way, the computer program according to an embodiment disclosed in this document may be implemented as a module that performs, for example, each function shown in FIG. 2, by being recorded in the memory 820 and processed by the MCU 810.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

**Claims**

1. A battery diagnosis device, comprising:

   a memory configured to store at least one instruction; and
   at least one processor configured to execute the at least one instruction,
   wherein the at least one processor is configured to:

   acquire an open circuit voltage (OCV) for each first charge amount according to a charge amount indicating an amount of charge charged in a battery cell, based on at least one of charging data of the battery cell, discharging data of the battery cell, or any combination thereof;
   acquire a degradation indicator based on the open circuit voltage for each first charge amount; and
   diagnose a state of the battery cell based on the degradation indicator.

2. The battery diagnosis device of claim 1, wherein the at least one processor is configured to:

   identify an open circuit voltage corresponding to the charge amount based on a) a first voltage value of the battery cell corresponding to the charge amount and included in the charging data, b) a first current value of the battery cell corresponding to the charge amount and included in the charging data, c) a second voltage value of the battery cell corresponding to the charge amount and included in the discharging data, and d) a second current value of the battery cell corresponding to the charge amount and included in the discharging data; and
   identify the open circuit voltage for each first charge amount based on the charge amount and the open circuit voltage.

3. The battery diagnosis device of claim 2, wherein the at least one processor is configured to:

   identify a voltage value of the battery cell corresponding to a current value of the battery cell when the current value of the battery cell is less than a specified current value, according to a linear equation identified based on a relationship between the first current value and the first voltage value and a relationship between the second current value and the second voltage value; and
   identify an open circuit voltage corresponding to the charge amount based on a voltage value of the battery cell.

4. The battery diagnosis device of claim 1, wherein the at least one processor is configured to:

   acquire a parameter based on at least one of i) an optimization algorithm, ii) an open circuit voltage for each charge amount of the battery cell in a middle of life (MOL) state indicated by the open circuit voltage for each first charge amount, iii) an open circuit voltage for each third charge amount of the battery cell in a beginning of life (BOL) state, iv) an open circuit potential (OCP) for each charge amount of the battery cell in the BOL state, or v) any combination thereof; and
   acquire the degradation indicator based on the parameter.

5. The battery diagnosis device of claim 4, wherein the at least one processor is configured to perform the optimization algorithm using a genetic algorithm (GA).

6. The battery diagnosis device of claim 1, wherein the at least one processor is configured to acquire at least one of the charging data, the discharging data, or any combination thereof, based on a charging and discharging profile through which the battery cell is charged with a current value higher than a reference current a specific number of times less than a reference number of times from a lower limit amount of charge higher than a first reference amount of charge to an upper limit amount of charge lower than a second reference amount of charge, and the battery cell is discharged at a current value a specific number of times from the upper limit amount of charge to the lower limit amount of charge.

7. The battery diagnosis device of claim 1, wherein the degradation indicator includes:

a loss of lithium inventory (LLI), which includes a first parameter related to lithium loss of the battery cell in a middle of life (MOL) compared to a beginning of life (BOL) ;
a first loss of active material (LAM), which includes a second parameter related to a loss of active material in a negative electrode plate of the battery cell in the MOL compared to the BOL; or
a second loss of active material (LAM), which includes a third parameter related to a loss of active material in a positive electrode plate of the battery cell in the MOL compared to the BOL.

8. A battery diagnosis method comprising:

an operation of acquiring an open circuit voltage (OCV) for each first charge amount according to a charge amount indicating an amount of charge charged in a battery cell, based on at least one of charging data of the battery cell, discharging data of the battery cell, or any combination thereof;
an operation of acquiring a degradation indicator based on the open circuit voltage for each first charge amount; and
an operation of diagnosing a state of the battery cell based on the degradation indicator.

9. The battery diagnosis method of claim 8, wherein the operation of acquiring the open circuit voltage (OCV) for each first charge amount according to a charge amount indicating an amount of charge charged in a battery cell, based on at least one of charging data of the battery cell, discharging data of the battery cell, or any combination thereof includes:

an operation of identifying an open circuit voltage corresponding to the charge amount based on a) a first voltage value of the battery cell corresponding to the charge amount and included in the charging data, b) a first current value of the battery cell corresponding to the charge amount and included in the charging data, c) a second voltage value of the battery cell corresponding to the charge amount and included in the discharging data, and d) a second current value of the battery cell corresponding to the charge amount and included in the discharging data; and
an operation of identifying the open circuit voltage for each first charge amount based on the charge amount and the open circuit voltage.

10. The battery diagnosis method of claim 9, wherein the operation of identifying the open circuit voltage corresponding to the charge amount based on a) the first voltage value of the battery cell corresponding to the charge amount and included in the charging data, b) the first current value of the battery cell corresponding to the charge amount and included in the charging data, c) the second voltage value of the battery cell corresponding to the charge amount and included in the discharging data, and d) the second current value of the battery cell corresponding to the charge amount and included in the discharging data includes:

an operation of identifying a voltage value of the battery cell corresponding to a current value of the battery cell when the current value of the battery cell is less than a specified current value, according to a linear equation identified based on a relationship between the first current value and the first voltage value and a relationship between the second current value and the second voltage value; and
an operation of identifying an open circuit voltage corresponding to the charge amount based on a voltage value of the battery cell.

11. The battery diagnosis method of claim 8, wherein the operation of acquiring the degradation indicator based on the open circuit voltage for each first charge amount includes:

an operation of acquiring a parameter based on at least one of i) an optimization algorithm, ii) an open circuit voltage for each charge amount of the battery cell in a middle of life (MOL) state indicated by the open circuit voltage for each first charge amount, iii) an open circuit voltage for each third charge amount of the battery cell in a beginning of life (BOL) state, iv) an open circuit potential (OCP) for each charge amount of the battery cell in the BOL state, or v) any combination thereof; and
an operation of acquiring the degradation indicator based on the parameter.

12. The battery diagnosis method of claim 11, wherein the operation of acquiring the parameter based on at least one of i) the optimization algorithm, ii) the open circuit voltage for each charge amount of the battery cell in the MOL state indicated by the open circuit voltage for each first charge amount, iii) the open circuit voltage for each third charge amount of the battery cell in the BOL state, iv) the open circuit potential for each charge amount of the battery cell in the BOL state, or v) any combination thereof includes an operation of performing the optimization algorithm using a genetic algorithm (GA).

13. The battery diagnosis method of claim 8, further comprising:

an operation of charging the battery cell with a current value higher than a reference current a specific number of times less than a reference number of times from a lower limit amount of charge higher than a first reference amount of charge to an upper limit amount of charge lower than a second reference amount of charge; and
an operation of acquiring at least one of the charging data, the discharging data, or any combination thereof based on a charging and discharging profile through which the battery cell is discharged at a current value a specific number of times from the upper limit amount of charge to the lower limit amount of charge.

14. The battery diagnosis method of claim 8, wherein the degradation indicator includes:

a loss of lithium inventory (LLI), which includes a first parameter related to lithium loss of the battery cell in a middle of life (MOL) compared to a beginning of life (BOL) ;
a first loss of active material (LAM), which includes a second parameter related to a loss of active material in a negative electrode plate of the battery cell in the MOL compared to the BOL; or
a second loss of active material (LAM), which includes a third parameter related to a loss of active material in a positive electrode plate of the battery cell in the MOL compared to the BOL.

F I G . 1

BATTERY DIAGNOSIS DEVICE
201

MEMORY
203

AT LEAST ONE PROCESSOR
205

FIG.2

EP 4 768 964 A1

| SIGNAL_KST_TS | pack_volt | pack_curr | state | time | Q | soc_rate |
|---|---|---|---|---|---|---|
| 0 | 2.962908 | 21.022230 | 1 | 1.000000 | 0.005721 | 1.070162 |
| 1 | 2.967854 | 21.020355 | 1 | 2.000000 | 0.011560 | 1.079430 |
| 2 | 2.971783 | 21.016176 | 1 | 3.000000 | 0.017397 | 1.088595 |
| 3 | 2.975286 | 21.013293 | 1 | 4.000000 | 0.023235 | 1.097962 |
| 4 | 2.978490 | 21.016318 | 1 | 5.000000 | 0.029072 | 1.107227 |
| ... | ... | ... | ... | ... | ... | ... |
| 21547 | 2.514717 | -21.001352 | 4 | 26896.460449 | 64.248043 | 1.070162 |
| 21548 | 2.510397 | -21.000197 | 4 | 26897.460449 | 64.253875 | 1.079430 |
| 21549 | 2.505939 | -21.001207 | 4 | 26898.460449 | 64.259711 | 1.088595 |
| 21550 | 2.501490 | -21.001928 | 4 | 26899.460449 | 64.265543 | 1.097962 |
| 21551 | 2.499909 | -20.999045 | 4 | 26899.839355 | 64.267762 | 1.107227 |

301

311

FIG.3

FIG.4

VOLTAGE (V)

CHARGE AMOUNT (Ah)

—··—··—503
—·—·—505
——————507
—————509

501

FIG.5

FIG.6

EP 4 768 964 A1

START

```
ACQUIRE OPEN CIRCUIT VOLTAGE FOR EACH
FIRST CHARGE AMOUNT ACCORDING TO CHARGE AMOUNT,
WHICH REPRESENTS AMOUNT OF CHARGE CHARGED IN BATTERY CELL,
BASED ON AT LEAST ONE OF CHARGING DATA OF BATTERY CELL,
DISCHARGING DATA OF BATTERY CELL, OR COMBINATION THEREOF
```
~701

```
ACQUIRE DEGRADATION INDICATOR BASED ON
OPEN CIRCUIT VOLTAGE FOR EACH FIRST CHARGE AMOUNT
```
~703

DIAGNOSE STATE OF BATTERY CELL BASED ON DEGRADATION INDICATOR ~705

END

FIG.7

800

```
      +------------------+         +------------------------+
      |     MEMORY       |         |  COMMUNICATION  I/F    |
      |      820         |         |         840            |
      +------------------+         +------------------------+
              |                              |
    ----------+----------------+-------------+---------------
              |                |
      +------------------+   +------------------------+
      |      MCU         |   |  INPUT/OUTPUT  I/F     |
      |      810         |   |         830            |
      +------------------+   +------------------------+
```

FIG.8

**TRANSLATION**

### INTERNATIONAL SEARCH REPORT

International application No.

**PCT/KR2025/009249**

**A. CLASSIFICATION OF SUBJECT MATTER**

**G01R 31/392**(2019.01)i; **G01R 31/396**(2019.01)i; **G01R 31/3842**(2019.01)i; **G01R 31/367**(2019.01)i; **G01R 31/36**(2006.01)i

According to International Patent Classification (IPC) or to both national classification and IPC

**B. FIELDS SEARCHED**

Minimum documentation searched (classification system followed by classification symbols)

G01R 31/392(2019.01); B60L 58/12(2019.01); G01R 19/00(2006.01); G01R 31/36(2006.01); G01R 31/364(2019.01); G01R 31/367(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전(charge), 퇴화(degradation), 전압(voltage)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2022-0034543 A (SAMSUNG SDI CO., LTD.) 18 March 2022 (2022-03-18) <br> paragraphs [0005]-[0063] and figures 1-3 | 1-14 |
| Y | KR 10-2022-0134391 A (LG ENERGY SOLUTION, LTD.) 05 October 2022 (2022-10-05) <br> paragraphs [0044]-[0074] and figures 1-5 | 1-14 |
| A | KR 10-2019-0123172 A (SAMSUNG SDI CO., LTD.) 31 October 2019 (2019-10-31) <br> paragraphs [0034]-[0161] and figures 1-6 | 1-14 |
| A | KR 10-2024-0061500 A (SNS CO., LTD. et al.) 08 May 2024 (2024-05-08) <br> paragraphs [0021]-[0030] and figure 1 | 1-14 |
| A | JP 2017-026443 A (SUZUKI MOTOR CORP.) 02 February 2017 (2017-02-02) <br> paragraphs [0018]-[0063] and figures 1-14 | 1-14 |

☐ Further documents are listed in the continuation of Box C.  ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **24 September 2025** | **24 September 2025** |

| Name and mailing address of the ISA/KR | Authorized officer |
|---|---|
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2025/009249**

| Patent document cited in search report | | | Publication date (day/month/year) | Patent family member(s) | | | Publication date (day/month/year) |
|---|---|---|---|---|---|---|---|
| KR | 10-2022-0034543 | A | 18 March 2022 | CN | 116113837 | A | 12 May 2023 |
| | | | | EP | 4212896 | A1 | 19 July 2023 |
| | | | | JP | 2023-541417 | A | 02 October 2023 |
| | | | | KR | 10-2572652 | B1 | 31 August 2023 |
| | | | | US | 2023-0358810 | A1 | 09 November 2023 |
| | | | | WO | 2022-055080 | A1 | 17 March 2022 |
| KR | 10-2022-0134391 | A | 05 October 2022 | CN | 115917343 | A | 04 April 2023 |
| | | | | EP | 4152025 | A1 | 22 March 2023 |
| | | | | JP | 2023-526931 | A | 26 June 2023 |
| | | | | JP | 7467820 | B2 | 16 April 2024 |
| | | | | KR | 10-2754173 | B1 | 10 January 2025 |
| | | | | US | 2023-0266400 | A1 | 24 August 2023 |
| | | | | WO | 2022-203367 | A1 | 29 September 2022 |
| KR | 10-2019-0123172 | A | 31 October 2019 | CN | 112005124 | A | 27 November 2020 |
| | | | | CN | 112005124 | B | 01 August 2023 |
| | | | | EP | 3786653 | A1 | 03 March 2021 |
| | | | | EP | 3786653 | B1 | 19 June 2024 |
| | | | | HU | E068533 | T2 | 28 January 2025 |
| | | | | JP | 2021-520178 | A | 12 August 2021 |
| | | | | JP | 7095110 | B2 | 04 July 2022 |
| | | | | KR | 10-2650965 | B1 | 25 March 2024 |
| | | | | PL | 3786653 | T3 | 02 September 2024 |
| | | | | US | 11366171 | B2 | 21 June 2022 |
| | | | | US | 2021-0048480 | A1 | 18 February 2021 |
| | | | | WO | 2019-208924 | A1 | 31 October 2019 |
| KR | 10-2024-0061500 | A | 08 May 2024 | KR | 10-2688734 | B1 | 26 July 2024 |
| JP | 2017-026443 | A | 02 February 2017 | JP | 6471636 | B2 | 20 February 2019 |

Form PCT/ISA/210 (patent family annex) (July 2022)

**EP 4 768 964 A1**

**Patent documents cited in the description**

- KR 1020240102814